(19) Europäisches Patentamt
European Patent Office
Office européen des brevets

(11) **EP 4 317 958 A1**

(12) **EUROPEAN PATENT APPLICATION**
published in accordance with Art. 153(4) EPC

(43) Date of publication:
**07.02.2024 Bulletin 2024/06**

(21) Application number: **22775502.2**

(22) Date of filing: **18.03.2022**

(51) International Patent Classification (IPC):
*G01N 27/30* (2006.01)     *B32B 27/06* (2006.01)
*C01B 32/00* (2017.01)     *C23C 14/06* (2006.01)
*H01M 4/02* (2006.01)     *H01M 4/66* (2006.01)

(52) Cooperative Patent Classification (CPC):
**B32B 27/06; C01B 32/00; C23C 14/06;
G01N 27/30; H01M 4/02; H01M 4/66**

(86) International application number:
**PCT/JP2022/012852**

(87) International publication number:
**WO 2022/202715 (29.09.2022 Gazette 2022/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **23.03.2021 JP 2021048722
04.03.2022 JP 2022033622**

(71) Applicant: **Nitto Denko Corporation
Ibaraki-shi
Osaka 567-8680 (JP)**

(72) Inventors:
• **HAYASHIUCHI, Rie
Ibaraki-shi, Osaka 567-8680 (JP)**
• **HAISHI, Motoki
Ibaraki-shi, Osaka 567-8680 (JP)**
• **YAMADA, Kyotaro
Ibaraki-shi, Osaka 567-8680 (JP)**

(74) Representative: **Gill Jennings & Every LLP
The Broadgate Tower
20 Primrose Street
London EC2A 2ES (GB)**

(54) **ELECTRODE**

(57)     An electrode (1) includes a resin film (2) and a conductive carbon layer (4) in this order in a thickness direction. The conductive carbon layer (4) has an $sp^3$ bond. The electrode (1) has a thermal shrinkage of -0.2% or more and 0.2% or less when being heated at 150°C for 1 hour.

FIG. 1

EP 4 317 958 A1

Processed by Luminess, 75001 PARIS (FR)

**Description**

TECHNICAL FIELD

The present invention relates to an electrode.

BACKGROUND ART

An electrode including a film substrate and a carbon thin film has been known (for example, see Patent document 1 below). The carbon thin film described in Patent document 1 includes diamond-like carbon.
In such a case, the carbon thin film has an $sp^3$ bond.

Citation List

Patent Document

Patent Document 1: Patent Document 1: PCT International Publication No. WO2016/013478

SUMMARY OF THE INVENTION

PROBLEM TO BE SOLVED BY THE INVENTION

Such an electrode may be curved depending on the use and purpose. However, if the electrode described in Patent document 1 is curved, the carbon thin film, which is relatively brittle, is easily cracked. This adversely increases the resistance of the electrode.
The present invention provides an electrode in which damage to the conductive carbon layer can be suppressed even if the electrode is curved.

MEANS FOR SOLVING THE PROBLEM

The present invention [1] includes an electrode comprising: a resin film; and a conductive carbon layer in this order in a thickness direction, wherein the conductive carbon layer has an $sp^3$ bond, and wherein a thermal shrinkage of the electrode is -0.2% or more and 0.2% or less when the electrode is heated at 150°C for 1 hour.
The present invention [2] includes the electrode described in the above-described [1], wherein the conductive carbon layer has an $sp^2$ bond, and wherein a ratio of the number of $sp^3$ bonded atoms to a sum of the number of $sp^3$ bonded atoms and the number of $sp^2$ bonded atoms is 0.10 or more.
The present invention [3] includes the electrode described in the above-described [1] or [2], wherein the conductive carbon layer has a density of 1.8 g/cm$^3$ or more.

EFFECTS OF THE INVENTION

In the electrode of the present invention, damage to the conductive carbon layer can be suppressed even if the electrode is curved, and the rate of increase in the resistance before and after the curvature is suppressed.

BRIEF DESCRIPTION OF THE DRAWINGS

FIG. 1 is a cross-sectional view of one embodiment of the electrode of the present invention.
FIG. 2 illustrates a variation of the electrode.
FIG. 3 illustrates a variation of the electrode.
FIG. 4 illustrates a test A for measuring the rate of increase in resistance.
FIG. 5 illustrates a test B for measuring the rate of increase in resistance.

DESCRIPTION OF THE EMBODIMENT

<One Embodiment>

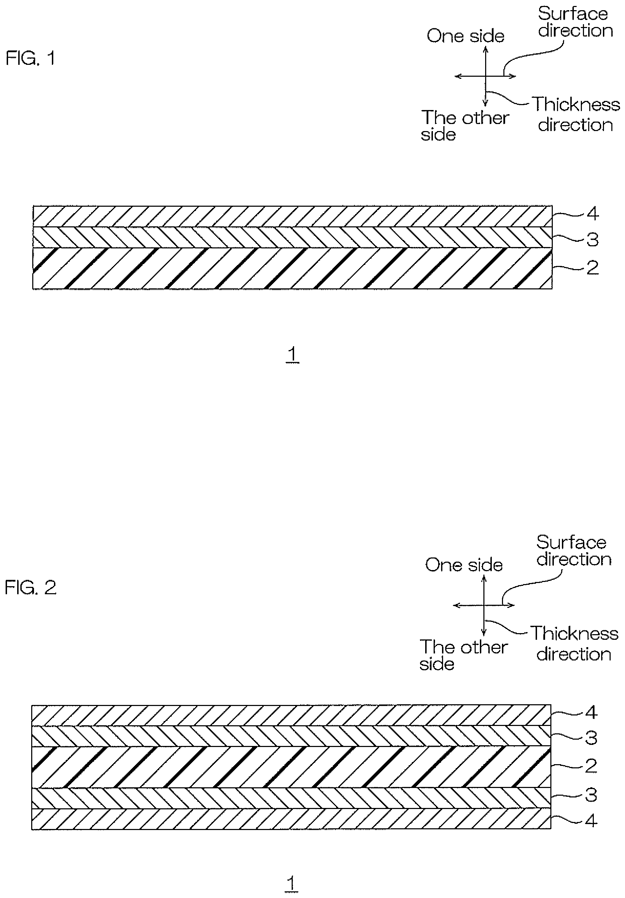

One embodiment of the electrode of the present invention is described with reference to FIG. 1.

(Electrode 1)

As illustrated in FIG. 1, an electrode 1 has a predetermined thickness. The electrode 1 has a film shape (including a sheet shape) extending in a surface direction. The surface direction is orthogonal to a thickness direction. The electrode 1 has a one-side surface and the other-side surface that are separated from each other by an interval in the thickness direction.

(Thermal Contraction Coefficient of Electrode 1)

When being heated at 150°C for 1 hour, the electrode 1 has a thermal shrinkage of - 0.2% or more and 0.2% or less.
Where the thermal shrinkage of the electrode 1 is less than -0.2% or more than 0.2%, the electrode 1 easily expands and contracts when the electrode 1 is curved. Thus, damage to a conductive carbon layer 4 described below cannot be suppressed, and the rate of increase in the resistance of the conductive carbon layer 4 increases.
To measure the thermal shrinkage of the electrode 1, the electrode 1 is heated at 150°C and atmospheric pressure in the air for 1 hour. Then, the thermal shrinkage of the electrode 1 is obtained by measuring the length of the electrode 1 before and after the heating.
The thermal shrinkage of the electrode 1 is preferably -0.15% or more, more preferably -0.1% or more, and, preferably 0.15% or less, more preferably 0.1% or less.
The above-described electrode 1 includes a resin film 2, a metal underlying layer 3, and the conductive carbon layer 4 in this order toward one side in the thickness direction. Specifically, the electrode 1 includes the resin film 2, the metal underlying layer 3 disposed on a one-side surface of the resin film 2 in the thickness direction, and the conductive carbon layer 4 disposed on a one-side surface of the metal underlying layer 3 in the thickness direction. Preferably, the electrode 1 consists of the resin film 2, the metal underlying layer 3, and the conductive carbon layer 4. Each of the layers is described in detail below.

(Resin Film 2)

The resin film 2 forms the other-side surface of the electrode 1 in the thickness direction. The resin film 2 has a film shape extending in the surface direction. The resin film 2 is the substrate film of the electrode 1. The resin film 2, for example, has flexibility. Examples of the material of the resin film 2 include polyester resin (for example, polyethylene terephthalate, polybutylene telephthalate, and polyethylene naphthalate), acetate resin, polyether sulfone resin, polycarbonate resin, polyamide resin, polyolefin resin (for example, polyethylene, polypropylene, and polycycloolefin polymer), (meth)acrylic resin, polyvinyl chloride resin, polyvinylidene chloride resin, polystyrene resin, polyvinyl alcohol resin, polyarylate resin, and polyphenylenesulfide resin. As the material of the resin film 2, in view of the thermal stability, polyester resin is preferable, and polyethylene terephthalate is more preferable.
The thickness of the resin film 2 is not limited. The thickness of the resin film 2 is, for example, 2 $\mu$m or more, preferably 20 $\mu$m or more, and, for example, 1000 $\mu$m or less, preferably 500 $\mu$m or less.

(Metal Underlying layer 3)

The metal underlying layer 3 is in contact with the one-side surface of the resin film 2 in the thickness direction. The metal underlying layer 3 extends in the surface direction. The metal underlying layer 3 is an intermediate layer located between the resin film 2 and the conductive carbon layer 4.
The material of the metal underlying layer 3 is not limited. Examples of the material of the metal underlying layer 3 include the metal elements classified into group 3 to group 14 of the periodic table prescribed by IUPAC in 2019. In view of chemical stability, titanium is preferable.
The thickness of the metal underlying layer 3 is not limited. The thickness of the metal underlying layer 3 is, for example, 1 nm or more, preferably 5 nm or more, and 100 nm or less, preferably 50 nm or less.

(Conductive Carbon Layer 4)

The conductive carbon layer 4 has electrical conductivity. The conductive carbon layer 4 forms the one-side surface of the electrode 1 in the thickness direction. The conductive carbon layer 4 is in contact with the one-side surface of the metal underlying layer 3 in the thickness direction. The conductive carbon layer 4 extends in the surface direction.

The conductive carbon layer 4, for example, has at least an $sp^3$ bond. Specifically, the conductive carbon layer 4 contains carbon at least having an $sp^3$ bond. In other words, the conductive carbon layer 4 at least has a diamond structure. This makes the conductive carbon layer 4 have high sensitivity to the object to be measured.

The conductive carbon layer 4 preferably has an $sp^2$ bond and an $sp^3$ bond. More specifically, the conductive carbon layer 4 contains carbon having an $sp^2$ bond and carbon having an $sp^3$ bond. In other words, the conductive carbon layer 4 has a graphite structure and a diamond structure. Thus, the conductive carbon layer 4 has excellent electrical conductivity while having high sensitivity to the object to be measured.

Further, the conductive carbon layer 4 may contain, for example, oxygen in addition to carbon. Specifically, the conductive carbon layer 4 contains, for example, oxygen in the one-side surface of the conductive carbon layer 4 in the thickness direction.

The concentration ratio of oxygen to carbon (O/C) of the one-side surface of the conductive carbon layer 4 in the thickness direction is not limited.

Furthermore, the conductive carbon layer 4 is allowed to contain a trace of inevitable impurities other than oxygen.

In the conductive carbon layer 4, the ratio ($sp^3/sp^3 + sp^2$) of the number of $sp^3$ bonded atoms to the sum of the number of $sp^3$ bonded atoms and the number of $sp^2$ bonded atoms is, for example, 0.10 or more, preferably 0.20 or more, preferably 0.30 or more, more preferably 0.35 or more. When the ratio ($sp^3/sp^3 + sp^2$) of the number of the $sp^3$ bonded atoms is the above-described lower limit or more, the potential window of the electrode 1 is extended.

Further, the ratio ($sp^3/sp^3 + sp^2$) of the number of $sp^3$ bonded atoms to the sum of the number of $sp^3$ bonded atoms and the number of $sp^2$ bonded atoms is, for example, 0.9 or less, preferably 0.6 or less. When the ratio ($sp^3/sp^3 + sp^2$) of the number of the $sp^3$ bonded atoms is the above-described upper limit or less, the electrical conductivity of the conductive carbon layer 4 is secured and the decrease in the detection sensitivity of the electrode 1 can be suppressed.

The ratio ($sp^3/sp^3 + sp^2$) of the number of the $sp^3$ bonded atoms can be calculated based on the peak intensity of the $sp^2$ bond and the peak intensity of the $sp^3$ bond in the spectrum obtained by measuring the one-side surface of the conductive carbon layer 4 in the thickness direction with X-ray photoelectron spectroscopy.

The conductive carbon layer 4 has a density of, for example, 1.8 g/cm$^3$ or more, preferably 2.0 g/cm$^3$ or more, more preferably 2.1 g/cm$^3$ or more, even more preferably 2.2 g/cm$^3$ or more. When the density of the conductive carbon layer 4 is the above-described lower limit or more, the potential window of the electrode 1 is extended based on the fact that the ratio ($sp^3/sp^3 + sp^2$) of the number of the $sp^3$ bonded atoms is high. The density of the conductive carbon layer 4 is, for example, 4.0 g/cm$^3$ or less. The density of the conductive carbon layer 4 is obtained with an X-ray reflectivity technique.

The surface resistance of the one-side surface of the conductive carbon layer 4 in the thickness direction is, for example, $1.0 \times 10^4 \Omega/\square$ or less, preferably, $1.0 \times 10^3 \Omega/\square$ or less. The lower limit of the surface resistance of the conductive carbon layer 4 is not limited.

The conductive carbon layer 4 has a thickness of, for example, 0.1 nm or more, preferably 0.2 nm or more, and 100 nm or less, preferably 50 nm or less.

The thickness of the electrode 1 is the total thickness of the resin film 2, the metal underlying layer 3, and the conductive carbon layer 4 and specifically is, for example, 2 $\mu$m or more, preferably 20 $\mu$m or more, and, for example, 1000 $\mu$m or less, preferably 500 $\mu$m or less.

(Method of Producing Electrode 1)

Next, a method of producing the electrode 1 is described. The method of producing the electrode 1 includes the first step to the fourth step. In the production method, the first step to the fourth step are carried out in sequence.

(First Step)

In the first step, the resin film 2 is prepared.

(Second Step)

In the second step, the resin film 2 prepared in the first step is heated.

The heating of the resin film 2 is a step of setting the thermal shrinkage of the electrode 1 to -0.2% or more and 0.2% or less. The conditions for the heating are not limited. The heating is carried out at a temperature of, for example, 70°C or more, preferably 100°C or more, more preferably 130°C or more, and, for example, 200°C or less, preferably 180°C or less, more preferably 160°C or less. The heating is carried out for a period of time of, for example, 5 minutes or more, preferably 15 minutes or more, more preferably 30 minutes or more, and, for example, 10 hours or more, preferably 5 hours or more, more preferably 2 hours or more. The heating is carried out at normal pressure (0.1 Ma) or reduced pressure (less than 0.1 MPa). The atmosphere is air or an inert gas (including argon).

(Third Step)

In the third step, the metal underlying layer 3 is formed on the one-side surface of the resin film 2 in the thickness direction. The method of forming the metal underlying layer 3 is not limited. Examples of the method of forming the metal underlying layer 3 include a dry method. A PVD method is preferable, and a sputtering method is more preferable.

(Fourth Step)

In the fourth step, the conductive carbon layer 4 is formed on the one-side surface of the metal underlying layer 3 in the thickness direction. Examples of the method of forming the conductive carbon layer 4 include a dry method. Examples of the dry method include a PVD method (physical vapor deposition method) and a CVD method (chemical vapor deposition method). A PVD method is preferable. Examples of the PVD method include a sputtering technique, a vacuum deposition method, a laser deposition method, and an ion plating method (such as an arc deposition method). A sputtering technique is preferable.
Examples of the sputtering technique include an unbalanced magnetron sputtering technique (UBM sputtering technique), a high-power pulsed sputtering technique, an electron cyclotron resonance sputtering technique, an RF sputtering technique, a DC sputtering technique, a DC pulsed sputtering technique, and an ion beam sputtering technique. In view of facilitating the setting of the ratio of the number of the $sp^3$ bonded atoms within the above-described desired range, a DC sputtering technique is preferable and a DC magnetron sputtering technique is more preferable.
Examples of the target of the sputtering technique include sintered carbon. Examples of the sputtering gas include inert gases including Ar. The sputtering is carried out at a pressure of, for example, 1 Pa or less. The sputtering is carried out at a film formation temperature of, for example, 0°C or less, and, for example, 150°C or less.
The first step to the fourth step are carried out, thereby producing the above-described electrode 1.

(Use of Electrode 1)

The electrode 1 can be used as various electrodes and preferably used as the electrode for an electrochemical measurement to carry out an electrochemical measurement method, specifically, as the working electrode (working pole) to carry out cyclic voltammetry (CV), or as the working electrode (working pole) to carry out anodic stripping voltammetry (ASV).
At that time, in view of the operation and effect described below, the electrode 1 can be curved when being used. Specifically, the electrode 1 can be used while being fixed on a surface of a curved wall or being adhered to a rod-shaped substrate.

(Operation and Effect of One Embodiment)

The electrode 1 has a thermal shrinkage of -0.2% or more and 0.2% or less, namely, 0. Thus, even if the electrode 1 is curved, damage to the conductive carbon layer 4 can be suppressed and the rate of increase in the resistance before and after the curvature can be suppressed.
Further, when the ratio ($sp^3/sp^3 + sp^2$) of the number of $sp^3$ bonded atoms to the sum of the number of $sp^3$ bonded atoms and the number of $sp^2$ bonded atoms is 0.10 or more in the conductive carbon layer 4 of the electrode 1, the potential window of the electrode 1 is extended.
When the conductive carbon layer 4 of the electrode 1 has a density of 1.8 g/cm$^3$ or more, the potential window is extended based on the fact that the ratio ($sp^3/sp^3 + sp^2$) of the number of $sp^3$ bonded atoms is high.

(Variations)

In each of the variations, the same members and steps as in one embodiment will be given the same numerical references and the detailed description thereof will be omitted. Further, the variations can have the same operations and effects as those of one embodiment unless especially described otherwise. Furthermore, one embodiment and the variations can appropriately be combined.

Further, a resin film 2 having a low thermal shrinkage allowing the electrode 1 to have a thermal shrinkage of -0.2% or more and 0.2% or less may be prepared in advance in the first step without carrying out the second step. For example, by using a resin having a molecular structure with a low thermal shrinkage as a raw material, by heating the resin film 2 at the stage of molding the resin film 2 from the raw material, or by suppressing the tension during transportation, the thermal shrinkage of the resin film 2 may be suppressed.

As illustrated in FIG. 1, in one embodiment, the electrode 1 includes one resin film 2, one metal underlying layer 3, and one conductive carbon layer 4. On the other hand, as illustrated in FIG. 2, the electrode 1 may include one resin film 2, two metal underlying layers 3, and two conductive carbon layers 4. In other words, the electrode 1 may include two metal underlying layers 3 and two conductive carbon layers 4 relative to one resin film 2. In such a case, the conductive carbon layer 4, the metal underlying layer 3, the resin film 2, the metal underlying layer 3, and the conductive carbon layer 4 are disposed in this order toward one side in the thickness direction.

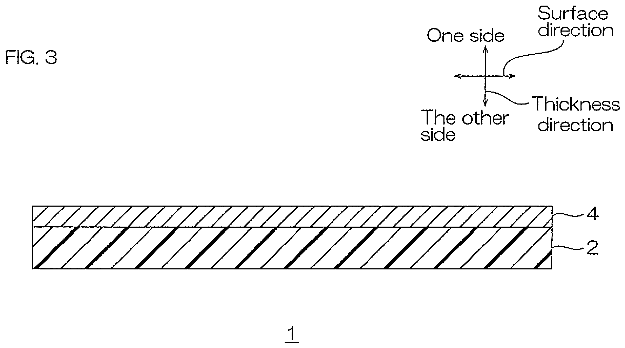

As illustrated in FIG. 3, the electrode 1 may include a resin film 2 and a conductive carbon layer 4 in sequence at one side in the thickness direction without including a metal underlying layer 3.

Examples

Next, the present invention is more specifically described with reference to Examples and Comparative Examples. The present invention is not limited to Examples and Comparative Examples in any way. The specific numeral values used in the description below, such as blending ratios (content ratios), physical property values, and parameters, can be replaced with the corresponding blending ratios (content ratios), physical property values, and parameters in the above-described "DESCRIPTION OF THE EMBODIMENTS", including the upper limit values (numeral values defined with "or less" or "less than") or the lower limit values (numeral values defined with "or more" or "more than"). Furthermore, the "parts" and "%" are based on mass unless otherwise specified.

First, methods of measuring the properties of each layer are described.

(Ratio of Number of $Sp^3$ Bonded Atoms in Conductive Carbon Layer 4)

The ratio ($sp^3/sp^3 + sp^2$) of the number of the $sp^3$ bonded atoms can be calculated based on the peak intensity of the $sp^2$ bond and the peak intensity of the $sp^3$ bond in the spectrum obtained by measuring the one-side surface of the conductive carbon layer 4 in the thickness direction with X-ray photoelectron spectroscopy.

(Thickness and Density)

The thickness of the conductive carbon layer 4 and the density of the conductive carbon layer 4 were obtained based on an X-ray reflectivity technique.

(Surface Resistance)

In conformity with JIS K 7194, the surface resistance of the electrode 1 on the conductive carbon layer 4 side was measured by a four-terminal method.

<Production of Electrode 1>

(Example 1)

A resin film 2 consisting of polyethylene terephthalate and having a thickness of 50 μm was prepared (the first step).

Subsequently, the resin film 2 was heated in an oven at 120°C for 1 hour (the second step).

Next, using DC magnetron sputtering, the metal underlying layer 3 consisting of titanium was formed on the one-side surface of the resin film 2 in the thickness direction (the third step). The conditions for the DC magnetron sputtering were as follows.

Targeted material: titanium
Target power: 100 W
Sputtering gas: Argon
Pressure in the sputtering chamber: 0.2 Pa

The thickness of the metal underlying layer 3 was 12 nm.

Using DC pulsed magnetron sputtering, the conductive carbon layer 4 was formed on a one-side surface of the metal underlying layer in the thickness direction (the fourth step). The conditions for the DC pulsed magnetron sputtering were as follows.

> Targeted material: sintered carbon
> Argon gas pressure: 0.4 Pa
> Target power: 2.0 W/cm$^2$
> Temperature: 120°C or less

The surface resistance of the conductive carbon layer 4 was $1.0 \times 10^2 \Omega/\square$. The ratio ($sp^3/sp^3 + sp^2$) of the number of $sp^3$ bonded atoms in the conductive carbon layer 4 was 0.35, and the density was 2.1 g/cm$^3$. The conductive carbon layer 4 had a thickness of 40 nm.

The above-described third step and fourth step were carried out using a roll-to-roll method.

In this manner, an electrode 1 was produced. Because being produced using the above-described roll-to-roll method, the electrode 1 had an MD direction and a TD direction.

(Example 2)

In the same manner as Example 1, an electrode 1 was produced. However, the heating temperature in the second step was changed from 120°C to 150°C.

(Example 3)

In the same manner as Example 2, an electrode 1 was produced. However, the conditions for the fourth step were changed as follows.

> Argon gas pressure: 0.2 Pa
> Target power: 1.7 W/cm$^2$

In the electrode 1 of Example 3, the surface resistance of the conductive carbon layer 4 was 140$\Omega/\square$. The ratio ($sp^3/sp^3 + sp^2$) of the number of $sp^3$ bonded atoms in the conductive carbon layer 4 was 0.45, and the density was 2.3 g/cm$^3$. The conductive carbon layer 4 had a thickness of 40 nm.

(Example 4)

In the same manner as Example 2, an electrode 1 was produced. However, the conditions for the fourth step were changed as follows.

> Argon gas pressure: 2 Pa
> Target power: 1.1 W/cm$^2$

In the electrode 1 of Example 4, the surface resistance of the conductive carbon layer 4 was 160$\Omega/\square$. The ratio ($sp^3/sp^3 + sp^2$) of the number of $sp^3$ bonded atoms in the conductive carbon layer 4 was 0.30, and the density was 1.8 g/cm$^3$. The conductive carbon layer 4 had a thickness of 40 nm.

(Comparative Example 1)

In the same manner as Example 1, an electrode 1 was produced. However, the second step was not carried out.

(Comparative Example 2)

In the same manner as Example 3, an electrode 1 was produced. However, the second step was not carried out.

(Comparative Example 3)

In the same manner as Example 4, an electrode 1 was produced. However, the second step was not carried out.

Of Each of Examples and Comparative Examples, the conditions for the second step or the presence or absence of the second step, the density of the conductive carbon layer 4, and the ratio ($sp^3/sp^3 + sp^2$) of the number of $sp^3$ bonded atoms are shown in Table 1.

<Evaluations>

The electrode 1 was used for the following evaluations. The results are shown in Table 1.

(Thermal Shrinkage of Resin Film 2)

A sample was produced by cutting the electrode 1 into a square with side length 30 mm. Subsequently, the sample was heated in an oven at 150°C for 1 hour. The dimensions of the electrode 1 were measured before and after the heating using Image Dimension Measuring System (manufactured by KEYENCE CORPORATION, IM-6020). The thermal shrinkage was obtained using the following formula.

$$\text{Thermal Shrinkage [\%]} = (\text{Length in MD Direction after Heating - Length in MD Direction before Heating})/\text{Length in MD Direction before Heating} \times 100$$

Generally, the thermal shrinkage in the MD direction is higher than the thermal shrinkage in the TD direction. Thus, in the above-described case, the thermal shrinkage in the MD direction was evaluated. However, when the electrode 1 was produced with a method in which a roll-to-roll method is not used, the evaluation may be carried out in the direction in which the absolute value of the thermal shrinkage is larger than in the other direction. The above-described method includes a batch-type method.

(Rate of Increase in Resistance of Electrode 1)

A sample 5 was produced by cutting the electrode 1 into a rectangle with longer sides of 70 mm and shorter sides of 20 mm. The direction of the longer sides is along the MD direction. The sample 5 was curved so that both-edge portions 6 of the sample 5 in the direction of the longer sides get close to each other. At the time, a center portion 7 of the sample 5 in the direction of the longer sides was wrapped around a metal rod 8 with its diameter of 6.5 mm. Further, the both-edge portions 6 of the sample 5 in the direction of the longer sides were fixed with a clip 10 with a weight 9 of 150 g and held for 10 seconds. The surface resistance of the central portion 7 of the electrode 1 was measured before and after the electrode 1 was curved. The rate of increase in the resistance was obtained using the following formula.

Rate of Increase in Resistance [%] = (Surface Resistance of Central Portion 7 of Electrode 1 after Curvature - Surface Resistance of Central Portion 7 of Electrode 1 before Curvature)/Surface Resistance of Central Portion 7 of Electrode 1 before Curvature $\times$ 100

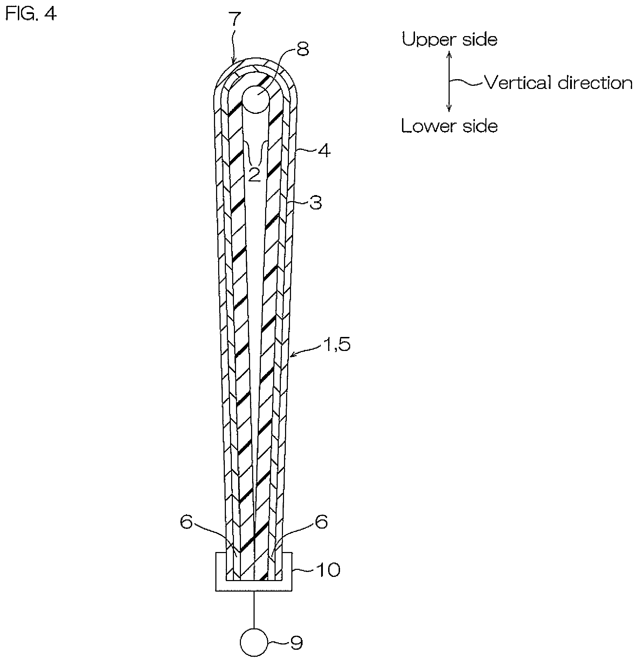

The test in which the resin film 2 faces itself as illustrated in FIG. 4 when the sample 5 is wrapped around the clip 10 is deemed test A. In test A, the rod 8, the resin film 2, the metal underlying layer 3, and the conductive carbon layer 4 are disposed in this order toward the upper side. In test A, a tensile force acts on the central portion of the conductive carbon layer 4.

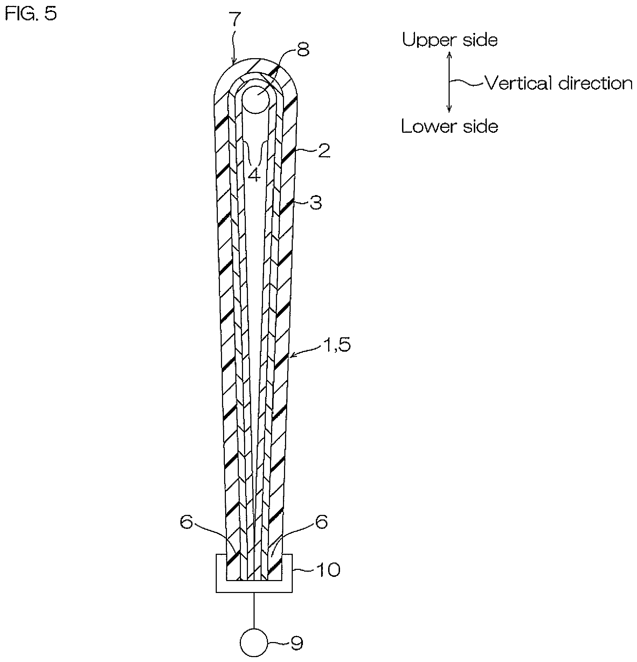

On the other hand, the test in which the conductive carbon layer 4 faces itself as illustrated in FIG. 5 when the sample 5 is wrapped around the clip 10 is deemed test B. In test B, the rod 8, the conductive carbon layer 4, the metal underlying layer 3, and the resin film 2 are disposed in this order toward the upper side. In test B, a compression force acts on the central portion of the conductive carbon layer 4.

[Table 1]

Table 1

| Examples-Comparative Examples | Second Step: Conditions for Heating Resin Film | Thermal Shrinkage of Electrode 1 [%] | Conductive Carbon Layer: Density [g/cm$^3$] | Conductive Carbon Layer: sp$^3$/(sp$^3$+sp$^2$) | Rate of Increase in Resistance [%]: Test A (Tension) — Resin Film | Rate of Increase in Resistance [%]: Test B (compression) — Conductive Carbon Layer |
|---|---|---|---|---|---|---|
| Example 1 | 120°C, 1 hour | -0.1 | 2.1 | 0.35 | 0.5 | 2.3 |
| Example 2 | 150°C, 1 hour | 0.0 | 2.1 | 0.35 | 0.6 | 0.5 |
| Example 3 | 150°C, 1 hour | 0.1 | 2.3 | 0.45 | 1.6 | 1.4 |
| Example 4 | 150°C, 1 hour | 0.0 | 1.8 | 0.30 | 0.5 | 0.6 |
| Comparative Example 1 | - | -0.3 | 2.1 | 0.35 | 3.2 | 3.8 |
| Comparative Example 2 | - | 0.3 | 2.3 | 0.45 | 3.9 | 3.4 |
| Comparative Example 3 | - | -0.3 | 1.8 | 0.30 | 1.2 | 2.7 |

While the illustrative embodiments of the present invention are provided in the above description, such is for illustrative purpose only and it is not to be construed as limiting in any manner. Modification and variation of the present invention that will be obvious to those skilled in the art is to be covered by the following claims.

Industrial Applicability

The electrode is used as the electrode for an electrochemical measurement.

Description of Reference Numerals

1    electrode

2    resin film

3    conductive carbon layer

**Claims**

1.    An electrode comprising: a resin film; and a conductive carbon layer in this order in a thickness direction,

wherein the conductive carbon layer has an sp$^3$ bond, and
wherein a thermal shrinkage of the electrode is -0.2% or more and 0.2% or less when the electrode is heated at 150°C for 1 hour.

2.    The electrode according to claim 1,

wherein the conductive carbon layer has an sp$^2$ bond, and
wherein a ratio of the number of sp$^3$ bonded atoms to a sum of the number of sp$^3$ bonded atoms and the number of sp$^2$ bonded atoms is 0.10 or more.

3. The electrode according to claim 1 or 2,
   wherein the conductive carbon layer has a density of 1.8 g/cm$^3$ or more.

FIG. 1

One side

Surface direction

The other side

Thickness direction

1

FIG. 2

One side

Surface direction

The other side

Thickness direction

1

FIG. 3

One side

Surface
direction

The other
side

Thickness
direction

4

2

1

FIG. 4

Upper side

Vertical direction

Lower side

FIG. 5

Upper side

↑
Vertical direction
↓

Lower side

<table>
<tr><td colspan="2" align="center">**INTERNATIONAL SEARCH REPORT**</td><td colspan="2">International application No.<br><br>**PCT/JP2022/012852**</td></tr>
</table>

**A.    CLASSIFICATION OF SUBJECT MATTER**

*G01N 27/30*(2006.01)i; *B32B 27/06*(2006.01)i; *C01B 32/00*(2017.01)i; *C23C 14/06*(2006.01)i; *H01M 4/02*(2006.01)i; *H01M 4/66*(2006.01)i

FI:    G01N27/30 B; B32B27/06; C01B32/00; C23C14/06 F; H01M4/02 Z; H01M4/66 A

According to International Patent Classification (IPC) or to both national classification and IPC

**B.    FIELDS SEARCHED**

Minimum documentation searched (classification system followed by classification symbols)

G01N27/30; B32B27/06; C01B32/00; C23C14/06; H01M4/02; H01M4/66

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JMEDPlus/JST7580 (JDreamIII)

**C.    DOCUMENTS CONSIDERED TO BE RELEVANT**

| Category* | Citation of document, with indication, where appropriate, of the relevant passages | Relevant to claim No. |
|---|---|---|
| A | JP 2020-144116 A (NITTO DENKO CORP) 10 September 2020 (2020-09-10)<br>claims, paragraphs [0020]-[0026], [0092], fig. 1 | 1-3 |
| A | WO 2020/196587 A1 (NITTO DENKO CORP) 01 October 2020 (2020-10-01)<br>entire text, all drawings | 1-3 |
| A | JP 2019-105637 A (NITTO DENKO CORP) 27 June 2019 (2019-06-27)<br>entire text, all drawings | 1-3 |
| A | WO 2016/013478 A1 (TOYOBO CO., LTD.) 28 January 2016 (2016-01-28)<br>claims, paragraphs [0023]-[0024], [0037] (diamond-like carbon) | 1-3 |
| P, A | JP 6970861 B1 (NITTO DENKO CORP) 24 November 2021 (2021-11-24)<br>entire text, all drawings | 1-3 |
| P, A | WO 2021/193631 A1 (NITTO DENKO CORP) 30 September 2021 (2021-09-30)<br>entire text, all drawings | 1-3 |

☐ Further documents are listed in the continuation of Box C.       ☑ See patent family annex.

| | |
|---|---|
| *    Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
|---|---|
| **30 May 2022** | **07 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/012852**

| Patent document cited in search report | | | Publication date (day/month/year) | Patent family member(s) | Publication date (day/month/year) |
|---|---|---|---|---|---|
| JP | 2020-144116 | A | 10 September 2020 | EP 3933394 A1 claims, paragraphs [0016]-[001 9], [0093], fig. 1 KR 10-2021-0129069 A | |
| WO | 2020/196587 | A1 | 01 October 2020 | KR 10-2021-0144722 A entire text, all drawings | |
| JP | 2019-105637 | A | 27 June 2019 | US 2021/0172897 A1 entire text, all drawings EP 3726207 A1 CN 111373248 A | |
| WO | 2016/013478 | A1 | 28 January 2016 | US 2017/0153200 A1 paragraphs [0035]-[0036], [0049] (diamond-like carbon) KR 10-2017-0036707 A | |
| JP | 6970861 | B1 | 24 November 2021 | (Family: none) | |
| WO | 2021/193631 | A1 | 30 September 2021 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016013478 A